# EUROPEAN PATENT APPLICATION

(11) **EP 1 783 793 A2**
(43) Date of publication of application: **09.05.2007**
(21) Application number: 06123336.7
(22) Date of filing: 02.11.2006
(51) Int. Cl.: H01G 9/20

(54) **Solar cell and manufacturing method thereof**

(30) Priority: 03.11.2005 KR 20050104883
(71) Applicant: Samsung SDI Co., Ltd., Suwon-si Gyeonggi-do (KR)
(72) Inventor: Ahn, Kwang-Soon, Kiheung-gu, Yongin-si, Kyunggi-do (KR); Lee, Ji-Won, Kiheung-gu, Yongin-si, Kyunggi-do (KR); Kang, Moon-Sung, Kiheung-gu, Yongin-si, Kyunggi-do (KR); Lee, Wha-Sup, Kiheung-gu, Yongin-si, Kyunggi-do (KR); Choi, Jae-Man, Kiheung-gu, Yongin-si, Kyunggi-do (KR); Shin, Byong-Cheol, Kiheung-gu, Yongin-si, Kyunggi-do (KR); Lee, Jae-Kwan, Kiheung-gu, Yongin-si, Kyunggi-do (KR); Park, Joung-Won, Kiheung-gu, Yongin-si, Kyunggi-do (KR); Kwon, Moon-Seok, Kiheung-gu, Yongin-si, Kyunggi-do (KR); Moon, Soo-Jin, Kiheung-gu, Yongin-si, Kyunggi-do (KR)
(74) Representative: Hengelhaupt, Jürgen

(57) **Abstract**

The invention concerns about a solar cell comprising:
an electrode (11); and
a first porous film (13) formed on the electrode (11) with pores and containing metallic oxide particles (131),

wherein the metallic oxide particles (131) have a mean particle diameter of 5nm to 14nm. The invention further concerns about a manufacturing method of the solar cell.

## Description

### BACKGROUND OF THE INVENTION

### 1. Field of the Invention

Aspects of the present invention relate to a solar cell, and in particular, to a high efficiency solar cell and a method of manufacturing the same.

### 2. Description of the Related Art

Generally, a solar cell generates electrical energy using solar energy, thereby supplying environmentally-friendly energy from an unlimited energy source with a long-term life span. Types of solar cells include silicon solar cells and dye-sensitized solar cells.

The dye-sensitized solar cell has better photoelectric conversion efficiency, lower production cost, and more flexible processing compared to the silicon solar cell. Furthermore, since the dye-sensitized solar cell has transparent electrodes, it may be used in constructing outer walls for buildings or greenhouses.

However, since the photoelectric conversion efficiency of solar cells is not high, solar cells are not yet in widespread use. Many studies have been carried out in order to enhance the photoelectric conversion efficiency, but most of the studies have been limited to the field of development of new dyes. In this connection, it is desirable that a new technology for enhancing the photoelectric conversion efficiency of the solar cell be developed.

### SUMMARY OF THE INVENTION

A solar cell with enhanced photoelectric conversion efficiency by improving the collection of electrons, and a method of manufacturing the solar cell are provided.

According to a first aspect of the present invention, there is provided a solar cell including an electrode and a first porous film formed on the electrode with pores and containing metallic oxide particles. The metallic oxide particles have a mean particle diameter of 5nm to 14nm. In addition, the pores of the first porous film may have a mean pore size of 7.5nm to 15nm.

The first porous film may have a thickness of 10nm to 3000nm, preferably of 10nm to 1000nm.

The metallic oxide particles of the first porous film may comprise at least one oxide selected from the group consisting of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminum oxide, yttrium oxide, scandium oxide, samarium oxide, gallium oxide and strontium titanium oxide. Preferably, the metallic oxide particles comprise at least one oxide selected from the group consisting of titanium oxide, tin oxide, tungsten oxide, and zinc oxide.

An additional porous film containing metallic oxide particles may be formed on the first porous film. The metallic oxide particles of the additional porous film have a mean particle diameter greater than that of the metallic oxide particles of the first porous film.

The mean particle diameter of the metallic oxide particles of the additional porous film may be in the range of 15nm to 50nm.

The additional porous film may be thicker than the first porous film. The additional porous film may have a thickness of 5 µm to 40 µm.

The metallic oxide particles of the additional porous film may comprise at least one oxide selected from the group consisting of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminum oxide, yttrium oxide, scandium oxide, samarium oxide, gallium oxide and strontium titanium oxide.

According to a second aspect of the present invention, there is provided a method of manufacturing the above mentioned solar cell. The method includes the steps of
providing a substrate with an electrode on its surface;
forming a first porous film with pores and containing metallic oxide particles through self-assembling process. Forming a first porous film may include preparing a self-assembling composition, coating the self-assembling composition onto an electrode, and heat-treating the coated composition.

The self-assembling composition may contain a solvent, a block copolymer, and a metallic oxide precursor. The solvent may be selected from acetyl acetone, alcohol, and a combination thereof. The block copolymer may be a ethylene oxide / propylene oxide block copolymer. The metallic oxide precursor may be a metallic compound selected from alkoxides, chlorides, and combinations thereof.

The self-assembling composition may be coated by dip coating, spin coating, or electrochemical coating.

Forming an additional porous film by coating a paste in which metallic oxide particles are diffused may be conducted after heat-treating the coated composition.

The heat-treating may be carried out at a temperature of between 350 °C and 500 °C.

In the self-assembling composition, the solvent may comprise from 60 to 90 wt.% of the self-assembling composition.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a sectional view of a solar cell according to an embodiment of the present invention;
FIG. 2 is a flow diagram of the steps of producing the solar cell shown in FIG. 1;
FIG. 3 is a sectional view of a solar cell according to another embodiment of the present invention;
FIG. 4 is an image of a surface of a porous film formed through self-assembling of a solar cell according to Example 1;
FIG. 5A is an image of a section of a first electrode, a porous film, and an additional porous film of the solar cell according to Example 1; FIG. 5B is an enlargement of the indicated area of 5B;
FIG. 6A is an image of a section of a first electrode and an additional porous film of a solar cell according to Comparative Example 1; FIG. 6B is an enlargement of the indicated area of 6B;
FIG. 7 is a graph illustrating the electric currents as functions of voltages of the solar cells according to Example 1 and Comparative Example 1;
FIG. 8 is a image of a section of a first electrode, a porous film, and an additional porous film of a solar cell according to Example 10;
FIG. 9 is a image of a section of a first electrode, a porous film, and an additional porous film of a solar cell according to Example 11; and
FIG. 10 is a image of a section of a first electrode and a porous film of a solar cell according to Example 12.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain aspects of the present invention by referring to the figures.

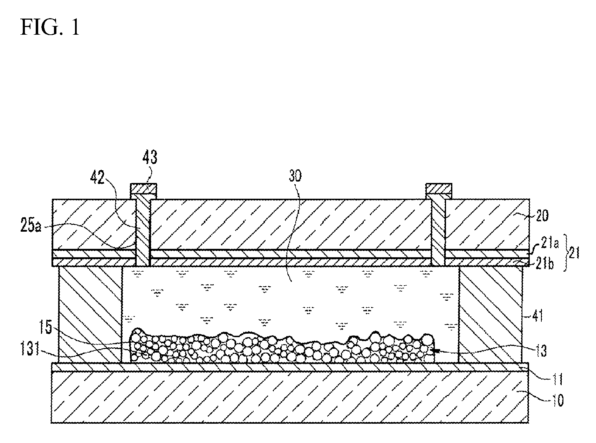

FIG. 1 is a sectional view of a solar cell according to an embodiment of the present invention.

As shown in FIG. 1, the solar cell according to the present embodiment includes a first substrate 10 and a second substrate 20 facing the first substrate 10. The first substrate 10 is provided with a first electrode 11, a first porous film 13, and a dye 15 adsorbed on the first porous film 13. (In the solar cell according to the embodiment of FIG. 1, the first porous film 13 is the only porous film formed on the first electrode 11.) The second substrate 20 is provided with a second electrode 21. An electrolyte 30 is disposed between the first and second electrodes 11 and 21. A separate case (not shown) may be placed external to the first and second substrates 10 and 20. This structure will now be explained more specifically.

In this embodiment, the first substrate 10 supports the first electrode 11, and is formed of a transparent material to allow external light to pass there through. The first substrate 10 may be formed of transparent glass or plastic. The plastic may be selected from polyethylene terephthalate (PET), polyethylene naphthalate (PEN), polycarbonate (PC), polypropylene (PP), polyimide (PI), and triacetyl cellulose (TAC). The first substrate 10 is not limited to these materials, and other materials are possible.

The first electrode 11, provided on the first substrate 10, may be formed of a transparent material, such as indium tin oxide (ITO), fluorine tin oxide (FTO), antimony tin oxide (ATO), zinc oxide, tin oxide, ZnO-Ga₂O₃, and ZnO-Al₂O₃. The first electrode 11 is not limited to these materials, and other materials are possible. The first electrode 11 may be formed as a transparent material-based single layer structure or laminated layer structure.

A first porous film 13 is formed on the first electrode 11. The first porous film 13 contains extremely fine metallic oxide particles 131 with even or uniform particle diameters and is formed through self-assembling. The metallic oxide particles 131 may be joined by interparticle necking. Furthermore, the first porous film 13 has very fine pores that also have even or uniform sizes. Hence, the first porous film 13 has a nanoporous characteristic.

The mean particle diameter of the metallic oxide particles 131 of the first porous film 13 may be in the range of 5nm-14nm. The mean particle diameter of the metallic oxide particles 131 and the extent of interparticle necking may be controlled by varying the firing or heat treating temperature required for the formation of the first porous film 13.

If the mean particle diameter of the metallic oxide particles 131 is less than 5nm, the temperature of the firing process required to form such particles is too low to form the first porous film 13 in a stable manner. By contrast, if the mean particle diameter of the metallic oxide particles 131 exceeds 14nm, the temperature of the firing process required to form such particles is so high that the first substrate 10 provided with the first porous film 13 may be damaged or bent. Furthermore, necking of the metallic oxide particles 131 is inhibited so that the amount the dye 15 that can be adsorbed on the first porous film 13 may be reduced. Accordingly, the efficiency of a solar cell containing the first porous film 13 may be lowered.

That is, in this embodiment, a first porous film 13 containing fine metallic oxide particles 131 with even particle diameters is formed on the first electrode 11, and necking of the metallic oxide particles 131 is improved so that the interface contact characteristic between the metallic oxide particles 131 and the first electrode 11 can be enhanced. Consequently, the interface contact characteristic between the first porous film 13 and the first electrode 11 is enhanced.

In this embodiment, the mean pore size of the pores of the first porous film 13 is in the range of 7.5nm-15nm. If the mean pore size of the first porous film 13 is less than 7.5nm, it is difficult for the electrolyte 30 to pass through the first porous film 13. By contrast, if the mean pore size exceeds 15nm, necking of the metallic oxide particles 131 is inhibited. When the first porous film 13 has a suitable mean pore size, the electrolyte 30 may easily pass there through, and necking of the metallic oxide particles 131 may be improved.

In this embodiment, the first porous film 13 may have a thickness of 10nm-3000nm. If the thickness of the first porous film 13 is less than 10nm, it is difficult for the first porous film 13 to function satisfactorily. By contrast, if the thickness of the first porous film 13 exceeds 3000nm, the relevant processing operations need to be repeated to form the first porous film 13, thereby complicating the overall process. Therefore, in order to stably form the first porous film 13 by a one-time process, the thickness of the first porous film 13 may be in the range of 10nm-1000nm. However, the thickness of the first porous film 13 is not limited thereto, and the thickness may be varied pursuant to technological development.

The metallic oxide particles 131 may be formed with titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminum oxide, yttrium oxide, scandium oxide, samarium oxide, gallium oxide, or strontium titanium oxide. It is preferable that the metallic oxide particles 131 are formed with titanium oxide of TiO₂, tin oxide of SnO₂, tungsten oxide of WO₃, zinc oxide of ZnO, or a combination thereof.

A dye 15 is adsorbed onto the surface of the first porous film 13 to absorb external light and generate excited electrons. The dye 15 may be formed with a metal complex containing aluminium (Al), platinum (Pt), palladium (Pd), europium (Eu), lead (Pb), iridium (Ir), or ruthenium (Ru). Since ruthenium, belonging to the platinum group, is capable of forming many organic metal complexes, a ruthenium-containing dye is commonly used. The metal complex is not limited to these materials, and other materials are possible. Furthermore, an organic dye may be also used, selected from coumarin, porphyrin, xanthene, riboflavin, and triphenylmethan. The organic dye is not limited to these materials, and other materials are possible.

The second substrate 20, which faces the first substrate 10 in the assembled solar cell, supports the second electrode 21, and is formed of a transparent material. As with the first substrate 10, the second substrate 20 may be formed of glass or plastic. The plastic may be selected from polyethylene terephthalate, polyethylene naphthalate, polycarbonate, polypropylene, polyimide, and triacetyl cellulose. The second substrate 21 is not limited to these materials, and other materials are possible.

The second electrode 21 formed on the second substrate 20 faces the first electrode 11, and includes a transparent electrode 21a and a catalyst electrode 21b. The transparent electrode 21 a may be formed of a transparent material such as indium tin oxide, fluorine tin oxide, antimony tin oxide, zinc oxide, tin oxide, ZnO-Ga₂O₃, and ZnO-Al₂O₃. The transparent electrode 21 a is not limited to these materials, and other materials are possible. The transparent electrode 21 a may be formed as a single layer structure based on the transparent material or as a laminated layer structure. The catalyst electrode 21 b activates a redox couple, and may be formed of platinum, ruthenium, palladium, iridium, rhodium Rh, osmium Os, carbon C, WO₃, or TiO₂. The catalyst electrode 21 b is not limited to these materials, and other materials are possible.

The first and second substrates 10 and 20 are attached to each other using an adhesive 41, and the electrolyte 30 is injected into the interior between the first and second electrodes 11 and 21 through holes 25a formed in the second substrate 20 and the second electrode 21. The electrolyte 30 is uniformly diffused into the first porous film 13. The electrolyte 30 receives and transfers electrons from the second electrode 21 to the dye 15 through reduction and oxidation. As a non-limiting example, the electrolyte may be an iodide-containing electrolyte. As a further non-limiting example, the electrolyte may comprise tetrapropylammonium iodide and iodine (I₂) in a solvent mixture of ethylene carbonate and acetonitrile. The holes 25a formed in the second substrate 20 and the second electrode 21 are sealed by an adhesive 42 and a cover glass 43. The electrolyte 30 is not limited to a liquid electrolyte as described herein. For example, the electrolyte 30 may be a gel or solid electrolyte.

When an external light, such as sunlight, hits the interior of the solar cell, photons are absorbed into the dye so that the dye is shifted from a ground state to an excited state, thereby generating excited electrons. The excited electrons migrate into the conduction bands of the metallic oxide particles 131 of the first porous film 13, and flow to an external circuit (not shown) through the first electrode 11. Thereafter, the electrons are transferred to the second electrode 21. Meanwhile, the iodide within the electrolyte 30 is oxidized into triiodide, and dye 15 that was oxidized by the transfer of electrons in response to the external light is reduced to its original state. The triiodide is reacts with the electrons transferred to the second electrode 21 and is thereby reduced to iodide. The solar cell thus operates due to the migration of the electrons.

Unlike other types of solar cells, such as a silicon solar cell, the dye-sensitized solar cell operates through an interface reaction at the interface between the first porous film 13 and the first electrode 11. Therefore, it is beneficial to improve the contact characteristics of the interface. In this embodiment, a first porous film 13 containing fine, uniform metallic oxide particles 131 is formed on the first electrode 11 to improve the interface contact characteristics between the first electrode 11 and the first porous film 13. Consequently, current collection is maximized to thereby enhance the photoelectric conversion efficiency.

Furthermore, in this embodiment, the mean pore size of the first porous film 13 is optimized so that the electrolyte 30 can easily pass through the first porous film 13 and necking of the metallic oxide particles 131 is improved. As a result, the photoelectric conversion efficiency can be further enhanced.

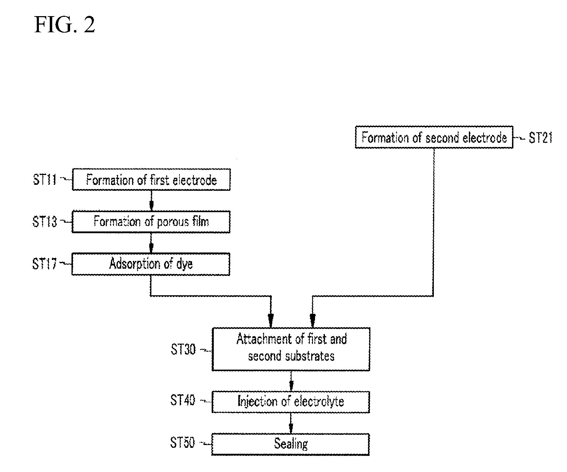

A method of manufacturing the solar cell will be specifically explained with reference to FIGs. 1 and 2. FIG. 2 is a flow diagram of the operations of processing the solar cell shown in FIG. 1. Detailed explanation of the materials for the above-identified structural components of the solar cell will be omitted.

A first electrode 11 is formed on a first substrate 10 (ST11). The first electrode 11 may be formed through sputtering, chemical vapour deposition, or spray pyrolysis deposition. The formation of the first electrode 11 is not limited to these methods, and other methods may be used.

Thereafter, a first porous film 13 is formed on the first electrode 11 through a self-assembly process (ST13). For this purpose, a self-assembling composition is first prepared and then coated onto the first electrode 11. The coated composition is heat-treated through a firing process. This will now be explained in more detail.

The self-assembling composition may contain a solvent, a block copolymer, and a precursor of metallic oxide. Various materials such as, for example, acetyl acetone and alcohol may be used as the solvent. The block copolymer may include, for example, an ethylene oxide / propylene oxide block copolymer. The metallic oxide precursor is capable of forming a predetermined metallic oxide, and may include, for example, metallic compounds including alkoxides and chlorides. The solvent may comprise about 60- 90wt.% of the self-assembling composition.

The self-assembling composition is coated onto the first electrode 11 through dip coating, spin coating, or electrochemical coating or other methods of coating. In consideration of the components and characteristics of the self-assembling composition, the coated composition is heat-treated so that the block copolymer is removed, and metallic oxide particles are formed from the metallic oxide precursor.

With the self-assembling composition for forming a first porous film 13, the metallic oxide precursor is uniformly diffused, thereby preventing the formation of metallic oxide particles with large particle diameters due to accumulation of the metallic oxide. Consequently, a first porous film 13 containing fine metallic oxide particles with uniform particle diameters and pores with a suitable mean pore size is formed. As the metallic oxide precursor on the first electrode 11 is converted into metallic oxide particles, the interface contact characteristics between the first porous film 13 and the first electrode 11 are further enhanced.

The first substrate 10, with the first porous film 13 and the first electrode 11 formed thereon, is dipped in a dye-dissolved alcoholic solution for a predetermined period of time, thereby adsorbing the dye 15 onto the first porous film 13 (ST17). However, the adsorbing of the dye 15 is not limited thereto and may be accomplished in various ways.

Meanwhile, a transparent electrode 21 a and a catalyst electrode 21 b are sequentially formed on a second substrate 20 to thereby form a second electrode 21 (ST21).

The transparent electrode 21 a may be formed through sputtering, chemical vapour deposition, or spray pyrolysis deposition. The formation of the transparent electrode 21 a is not limited to these methods, and other methods may be used.

The catalyst electrode 21 b may be formed through a physical vapour deposition method, such as, for example, electrolyte plating, sputtering, or electron beam deposition, or a wet coating method, such as, for example, spin coating, dip coating, or flow coating. If the catalyst electrode 21 b is formed of platinum, a solution of H₂PtCl₆ dissolved in an organic solvent, such as methanol, ethanol, or isopropyl alcohol (IPA), may be coated onto the transparent electrode 21 a through wet coating, and heat-treated at 400°C under an air or oxygen atmosphere. However, the formation of the catalyst electrode is not limited thereto, and the process may be conducted in various ways.

Holes 25a are formed in the second substrate 20 and the second electrode 21.

The first and second substrates 10 and 20 are arranged such that the first porous film 13 faces the second electrode 21, and are attached to each other using an adhesive 41 (ST30). A thermoplastic polymer film (such as, for example, a resin provided by DuPont under the registered trademark SURLYN^{™}), an epoxy resin, or an ultraviolet hardener may be used as the adhesive 41. If the adhesive 41 is formed of a thermoplastic polymer film, the thermoplastic polymer film may be disposed between the first and second substrates 10 and 20 and thermally pressed to thereby attach the first and second substrates 10 and 20 to each other.

An electrolyte 30 is injected into the interior between the first and second substrates 10 and 20 through the holes 25a formed in the second substrate 20 and the second electrode 21 (ST40). The present description is for when the electrolyte 30 is in a liquid phase. If the electrolyte is in a solid or gel phase, other techniques may be used to provide the electrolyte 30 between the first and second substrates, Solar cells having solid or gel electrolytes are also within the scope of the present invention.

The holes 25a are sealed using an adhesive 42 and a cover glass 43 (ST50), thereby completing a solar cell. A separate case (not shown) may be provided external to the first and second substrates 10 and 20.

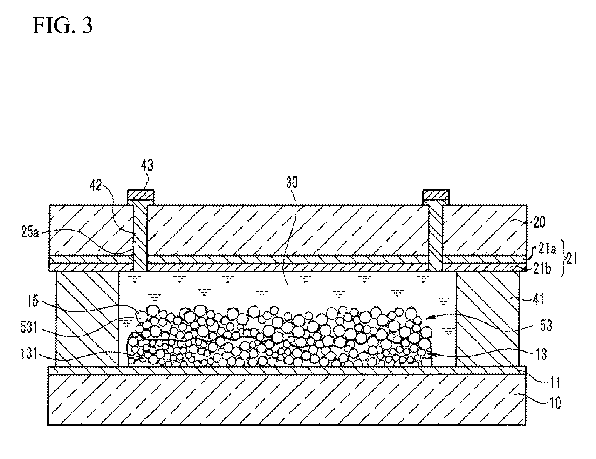

A solar cell according to another embodiment of the present invention and a method of manufacturing such will now be specifically explained with reference to FIG. 3. As the basic structural components of the solar cell according to the present embodiment are the same or similar to those described with reference to FIG. 1, explanation thereof will be omitted, and only the differences will be explained in detail. Like reference numerals will be used to refer to similar structural components shown in the drawings.

FIG. 3 is a sectional view of a solar cell according to another embodiment of the present invention.

In this embodiment, an additional porous film 53 containing metallic oxide particles 531 is formed on the first porous film 13. The mean particle diameter of the metallic oxide particles 531 is in the range of 15nm-50nm, which is greater than the mean particle diameter of the metallic oxide particles 131 for the first porous film 13. As a non-limiting example, the mean particle diameter of the metallic oxide particles 531 may be in the range of 15nm-40nm.

The additional porous film 53 may be formed through coating a paste in which nanometer-sized metallic oxide particles are diffused. The coating may be carried out by, for example, using a doctor blade, screen printing, spin coating, spraying, or wet coating, and then heat-treating the coated paste in a suitable manner.

The additional porous film 53 may be formed with a large thickness through a one-time process, and the additional porous film 53 may be thicker than the first porous film 13. The additional porous film 53 may have a thickness of 5 µm-40 µm, and, as a non-limiting example, may have a thickness of 10 µm -30 µm. However, the thickness of the additional porous film 53 is not limited thereto.

As with the first porous film 13, the additional porous film 53 may be formed of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide, or strontium titanium oxide. It is preferable, but not necessary, that the metallic oxide particles 531 of the additional porous film 53 are formed of titanium oxide of TiO₂, tin oxide of SnO₂, tungsten oxide of WO₃, zinc oxide of ZnO, or a combination thereof.

In order to enhance the performance characteristics of the additional porous film 53, conductive micro particles and light scattering particles may be added to the additional porous film 53. The conductive micro particles added to the additional porous film 53 may enhance the mobility of the excited electrons. For instance, the conductive micro particles may be based on indium tin oxide. The light scattering particles added to the additional porous film 53 extend the optical path within the solar cell to thereby enhance the photoelectric conversion efficiency thereof. The light scattering particles may be formed of the same material as the additional porous film 53. As a non-limiting example, the light scattering particles may have a mean particle diameter of 100nm or more to effectively scatter the light.

As described above, in this embodiment, the first porous film 13 and the additional porous film 53, each containing metallic oxide particles differentiated from each other in mean particle diameter, are sequentially formed so as to each thereby exert the advantageous effects thereof. The first porous film 13 serves to enhance the interface contact characteristics and the additional porous film 53 serves to increase the porous film thickness without increasing the number of processing steps.

However, aspects of the present invention are not limited thereto, and only the first porous film 13 may be formed, or additional separate porous films may be formed. Of course, a plurality of porous films may be formed with various arrangements.

The method of manufacturing the solar cell according to an aspect of the present embodiment further includes forming an additional porous film 53 after forming the first porous film 13. Other processing steps are the same as those related to FIG. 2 and the relevant description, and hence, explanation thereof will be omitted.

During the formation of the additional porous film 53, polyethylene oxide, polyethylene glycol, polyvinyl alcohol (PVA), or polyvinyl pyrrolidone may be added to the paste to enhance the porosity of the additional porous film 53 and the film formation adhesiveness thereof by increasing the diffusivity and viscosity of the paste. The polymer may be removed after heat treatment.

If a binder is present, the heat treatment may be carried out at 450-600°C for 30 minutes, while if no binder is present, the heat treatment may be carried out at 200°C or less. However, the heat treatment may be altered depending upon the composition of the paste, and the heat treatment is not limited to these temperatures.

In the method of manufacturing the solar cell according to an aspect of the present invention, a first porous film 13 with an excellent interface contact characteristic and an additional porous film 53 with a large thickness are sequentially formed to thereby enhance the efficiency and the process characteristics.

A solar cell according to an aspect of the present invention will now be specifically explained by way of Examples. The Examples are given only to illustrate aspects of the present invention, and are not intended to limit the scope of the present invention. Particularly, the Examples exemplify the formation of an additional porous film to specify the characteristics of the porous film formed through the self-assembly process.

### Example 1

A first electrode was formed of tin oxide on a first 1cm×1cm glass substrate, such that the first electrode had a surface resistivity of 10 Ω.

A self-assembling composition was prepared by adding a block copolymer of Pluronic P123 (Pluronic P123 is a difunctional ethylene oxide / propylene oxide block copolymer surfactant terminating in primary hydroxyl groups and avaible from BASF, Germany) (15wt.%) and a TiO₂ precursor of Ti 4-isopropoxide (TTIP) (21wt.%) to a solvent of acetyl acetone (64wt.%) to thereby form a self-assembling compound. The self-assembling composition was coated on the first electrode through dip coating with a speed of 5mm/min. The coated composition was aged at ambient temperature for one hour, and heat-treated at 450°C for 30 minutes during the firing process, thereby forming a TiO₂-containing porous film. The thickness of the porous film was 150nm.

A solution in which TiO₂ particles with a mean particle diameter of 15nm were diffused was coated onto the porous film through doctor blade method, thereby forming an additional TiO₂-containing porous film.

The first substrate with the first electrode, the porous film, and the additional porous film was dipped in 0.3mM of a solution of ruthenium (4,4-dicarboxy-2,2'-bipyridine)₂(NCS)₂ for 24 hours, thereby adsorbing the dye into the porous film. The dye-adsorbed porous film was cleaned using ethanol.

A tin oxide-based transparent electrode with a surface resistivity of 10 Ω, and a platinum-based catalyst electrode with a surface resistivity of 0.5 Ω were formed on a second 1 cm×1cm glass substrate, thereby forming a second electrode. Holes were formed in the second substrate and the second electrode using a drill with a diameter of 0.75m.

The first and second substrates were arranged such that the porous film formed on the first substrate faced the second electrode. A thermoplastic polymer film with a thickness of 60 µm was placed between the first and second electrodes, and thermally pressed at 100°C for 9 seconds to thereby attach the first and second substrates to each other.

An electrolyte was injected into the interior between the first and second substrates through the holes in the second substrate and the second electrode, and the holes were sealed using a thermoplastic polymer film and a cover glass, thereby completing a solar cell. The electrolyte was a solution formed by dissolving 21.928g of tetrapropylammonium iodide and 1.931g of iodine (I₂) in 100ml of a mixture solvent of 80vol.% of ethylene carbonate and 20vol.% of acetonitrile.

### Comparative Example 1

A solar cell was manufactured in the same way as in Example 1 except that only a porous film corresponding to the additional porous film of Example 1 was formed on the electrode. In other words, in Comparative Example 1, only a porous film having TiO₂ particles with a mean particle diameter of 15nm was formed, and a porous film having a smaller mean particle diameter and formed through a self-assembly process was not formed on the electrode.

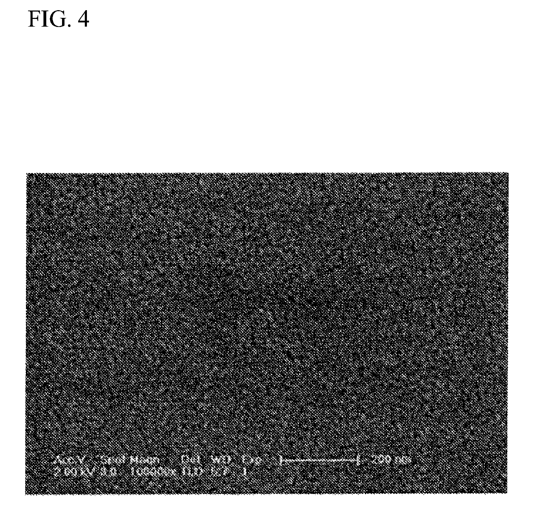

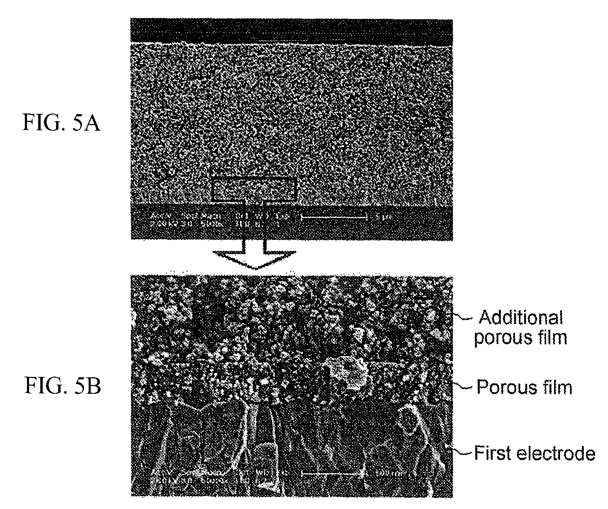

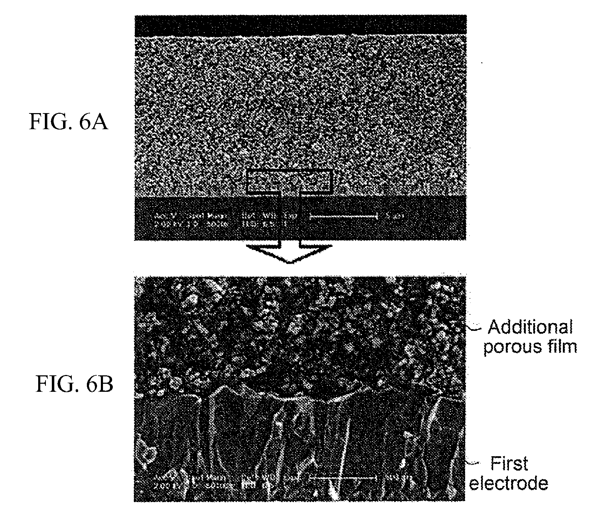

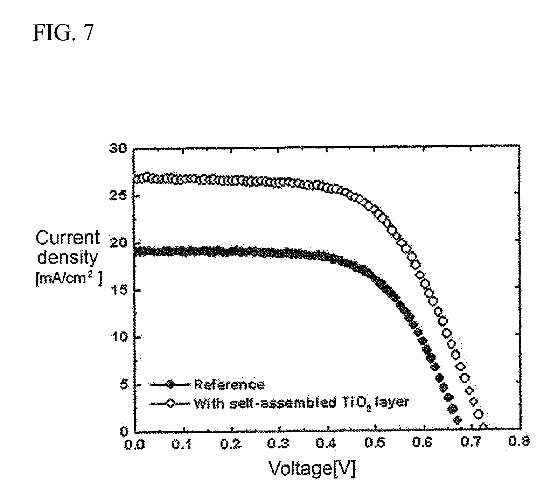

An image of a surface of the porous film formed through the self-assembly process of the solar cell according to Example 1 is shown in FIG. 4. Images of a section of the first electrode, the porous film, and the additional porous film of the solar cell according to Example 1 are shown in FIGs. 5A and 5B. Images of a section of the first electrode and the additional porous film of the solar cell according to Comparative Example 1 are shown in FIGs. 6A and 6B. Furthermore, the electric currents as functions of voltages of the solar cells according to Example 1 and Comparative Example 1 were measured using a light source comprising a xenon (Xe) lamp of 100mW/cm² and a filter of AM1.5. The measurement results are shown in FIG. 7. The data from FIG. 7 are summarized and listed in Table 1.

**Table 1**

| | Short circuit current density | Open circuit voltage | Fill factor | Efficiency |
|---|---|---|---|---|
| Ex. 1 | 26.88 | 0.72 | 0.60 | 11.64 |
| Com. Ex. 1 | 19.09 | 0.68 | 0.62 | 8.04 |

As shown in FIG. 4, the surface of the porous film formed through the self-assembly process of the solar cell according to Example 1 was very smooth without generating any cracks and was provided with extremely fine and even pores. The metallic oxide particles of the porous film were also formed with very fine and even particle diameters. Since such a porous film contacted the first electrode, the interface contact characteristic between the porous film and the first electrode was excellent.

Comparing FIGs. 5A and 5B with FIGs. 6A and 6B, it can be clearly seen that the interface contact characteristic between the surface of the porous film and the first electrode of the solar cell according to Example 1 is excellent (see FIG. 5B), while non-contact portions exist at the interface between the additional porous film and the first electrode of the solar cell according to Comparative Example 1 (see FIG. 6B). The metallic oxide particles were aggregated due to the heat treatment made during the formation of the additional porous film of the solar cell according to Comparative Example 1 and so aggregates with particle diameters of 200nm-1 000nm were generated, and the interface contact characteristic was therefore deteriorated due to the aggregates.

Referring to FIG. 7 and Table 1, the short circuit current density of the solar cell according to Example 1 is very high compared to that of the solar cell according to Comparative Example 1. This is because the interface contact characteristic between the porous film and the first electrode is enhanced in the solar cell according to Example 1 so that the excited electrons generated and transferred from the dye to the porous film can migrate easily to the first electrode.

Furthermore, it is shown that the solar cell according to Example 1 has a significantly higher efficiency than the solar cell according to Comparative Example 1, which may be due to the enhanced short circuit current density.

### Example 2

A solar cell was manufactured in the same way as in Example 1 except that in the formation of the porous film, the self-assembling compound was prepared by adding 4.5wt.% of P123 and 6.3wt.% of titanium 4-isopropoxide to 89.2wt.% of acetyl acetone, and heat-treated at 350°C during the firing process.

### Example 3

A solar cell was manufactured in the same way as in Example 2 except that in the formation of the porous film, the firing process was carried out at 400°C.

### Example 4

A solar cell was manufactured in the same way as in Example 2 except that in the formation of the porous film, the firing process was carried out at 450°C.

### Example 5

A solar cell was manufactured in the same way as in Example 2 except that in the formation of the porous film, the firing process was carried out at 500°C.

### Comparative Example 2

A solar cell was manufactured in the same way as in Example 2 except that in the formation of the porous film, the firing process was carried out at 300°C.

### Comparative Example 3

A solar cell was manufactured in the same way as in Example 2 except that in the formation of the porous film, the firing process carried out at 550°C.

With the solar cells according to Examples 2 to 5 and Comparative Examples 2 and 3, the mean particle diameter of the metallic oxide particles forming the porous film was measured. Furthermore, the electric currents as functions of voltages of the solar cells according to the Examples and Comparative Examples were measured using a light source of a xenon Xe lamp of 100mW/cm² and a filter of AM1.5. The measurement results are evaluated and listed in Table 2.

**Table 2**

| | Mean particle diameter [nm] | Short circuit current density | Open circuit voltage | Fill factor | Efficiency |
|---|---|---|---|---|---|
| Ex.2 | 5 | 21.6 | 0.67 | 0.64 | 9.26 |
| Ex. 3 | 8 | 23.1 | 0.69 | 0.64 | 10.2 |
| Ex. 4 | 10 | 24.14 | 0.69 | 0.66 | 10.91 |
| Ex. 5 | 14 | 22.3 | 0.68 | 0.67 | 10.16 |
| Com. Ex. 2 | - | - | - | - | - |
| Com. Ex. 3 | 20 | 20.3 | 0.69 | 0.65 | 9.1 |

Table 2 does not contain data related to Comparative Example 2, since when the firing process was carried out at 300°C the polymer material did not flow due to the lower temperature so that porous films were not formed. That is, considering that the mean particle diameter of the metallic oxide particles forming the porous film is smaller when the firing temperature is lower, it is difficult in practice to form metallic oxide particles with a mean particle diameter of less than 5nm when the firing temperature is lower than a predetermined degree.

As shown in Table 2, the solar cells according to Examples 2 to 5 had a short circuit current density significantly higher than that of the solar cell according to Comparative Example 3. This is because with the solar cells according to Examples 2 to 5, the porous film has even particle diameters, and the interface contact characteristic between the porous film and the first electrode is enhanced so that the excited electrons generated and transferred from the dye to the porous film can migrate easily to the first electrode. Furthermore, when that the mean particle diameter of the metallic oxide particles is large, as in the solar cell according to the Comparative Example 3, the amount of dye adsorption is reduced, thereby deteriorating the efficiency.

For this reason, the solar cells according to Examples 2 to 5 had efficiencies significantly higher than that of the solar cell according to Comparative Example 3. That is, when the mean particle diameter of the metallic oxide particles was in the range of 5nm-14nm, the solar cell had a high efficiency.

### Example 6

A solar cell was manufactured in the same way as in Example 4 except that in the formation of the porous film, the self-assembling compound was prepared by adding 4.5wt.% of P123 and 6.3wt.% of titanium 4-isopropoxide to 89.2wt.% of acetyl acetone.

### Example 7

A solar cell was manufactured in the same way as in Example 4 except that in the formation of the porous film, the self-assembling compound was prepared by adding 11.083wt.% of P123 and 15.517wt.% of titanium 4-isopropoxide to 73.4wt.% of acetyl acetone.

### Example 8

A solar cell was manufactured in the same way as in Example 4 except that in the formation of the porous film, the self-assembling compound was prepared by adding 12.5wt.% of P123 and 17.5wt.% of titanium 4-isopropoxide to 70wt.% of acetyl acetone.

### Example 9

A solar cell was manufactured in the same way as in Example 4 except that in the formation of the porous film, the self-assembling compound was prepared by adding 16.677wt.% of P123 and 23.355wt.% of titanium 4-isopropoxide to 60wt.% of acetyl acetone.

### Comparative Example 4

A solar cell was manufactured in the same way as in Example 4 except that in the formation of the porous film, the self-assembling compound was prepared by adding 2.5wt.% of P123 and 3.5wt.% of titanium 4-isopropoxide to 94wt.% of acetyl acetone.

### Comparative Example 5

A solar cell was manufactured in the same way as in Example 4 except that in the formation of the porous film, the self-assembling compound was prepared by adding 20wt.% of P123 and 28wt.% of titanium 4-isopropoxide to 52wt.% of acetyl acetone.

With the solar cells according to Examples 4 and 6 to 9 and Comparative Examples 4 and 5, even though the weight percent of the acetyl acetone was varied, the weight percent ratio of P123 to titanium 4-isopropoxide had the same value of 5/7.

With the solar cells according to Examples 4 and 6 to 9 and Comparative Examples 4 and 5, the mean particle diameter of the metallic oxide particles forming the porous film was measured. Furthermore, the electric currents as functions of voltages of the solar cells according to Examples 4 and 6 to 9 and Comparative Examples 4 and 5 were measured using a light source of a xenon Xe lamp of 100mW/cm² and a filter of AM1.5. The measurement results were evaluated and are listed in Table 3. In Table 3, the Examples and the Comparative Examples are listed in descending order according to the weight percent of the solvent. In other words, Comparative Example 4 has the highest weight percent of solvent (94wt.%) and Comparative Example 5 has the lowest weight percent of solvent (52wt.%), with Examples 4 and 6 to 9 falling in between.

**Table 3**

| | Mean pore size [nm] | Short circuit current density | Open circuit voltage | Fill factor | Efficiency |
|---|---|---|---|---|---|
| Com. Ex. 4 | 4 | 20.33 | 0.68 | 0.64 | 8.82 |
| Ex. 4 | 10 | 24.14 | 0.69 | 0.66 | 9.90 |
| Ex. 6 | 7.5 | 21.58 | 0.70 | 0.66 | 9.90 |
| Ex. 7 | 11 | 26.09 | 0.70 | 0.62 | 11.34 |
| Ex. 8 | 12 | 25.19 | 0.71 | 0.66 | 11.77 |
| Ex. 9 | 13 | 24.75 | 0.69 | 0.60 | 10.20 |
| Com. Ex. 5 | 25 | 20.12 | 0.68 | 0.64 | 8.73 |

It can be determined from Table 3 that the mean pore size of the porous film is gradually enlarged as the weight percent of the solvent is increased. This is assumed to be because the mean pore size of the porous film is influenced by the viscosity of the self-assembling compound.

As shown in Table 3, the solar cells according to Examples 4 and 6 to 9 were significantly enhanced in short circuit current density and efficiency compared to those according to Comparative Examples 4 and 5. The reason is that when the mean pore size is too small, as in the solar cell according to Comparative Example 4, it is difficult for the electrolyte to pass through the porous film, while when the mean pore size is too large, as in the solar cell according to Comparative Example 5, necking of the metallic oxide particles forming the porous film is inhibited.

### Example 10

A solar cell was manufactured in the same way as in Example 1 except that the porous film formed through the self-assembly process had a thickness of 750nm.

### Example 11

A solar cell was manufactured in the same way as in Example 1 except that the porous film formed through the self-assembly process had a thickness of 1070nm.

### Example 12

A solar cell was manufactured in the same way as in Example 1 except that the porous film formed through the self-assembly process had a thickness of 1320nm.

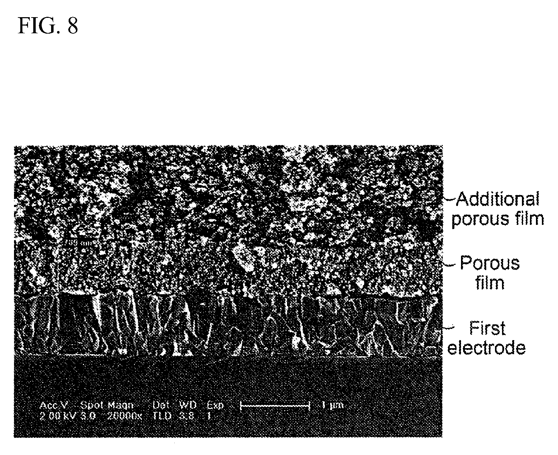

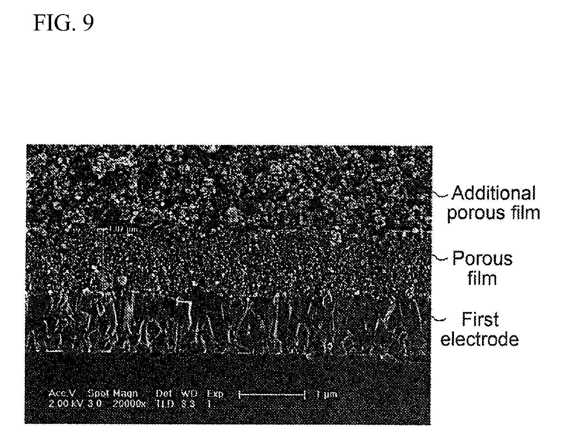

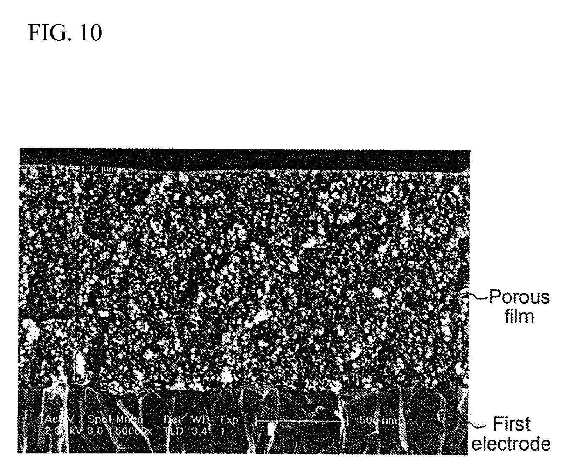

Images of sections of the first electrode, the porous film, and the additional porous film of the solar cells according to Examples 10 and 11 are shown in FIGs. 8 and 9, and an image of a same section of the solar cell according to Example 12 is shown in FIG. 10. The porous films of the solar cells according to Examples 10 to 12 were formed with very fine metallic oxide particles and even-sized pores. The porous film of the solar cell according to Example 10 with a thickness of less than 1000nm turned out to be more structurally stable compared to the porous films of the solar cells according to Examples 11 and 12.

As described above, a porous film formed through the self-assembly process according to an aspect of the present invention has even and fine metallic oxide particles and even and fine-sized pores. When the porous film contacts the electrode the interface contact characteristics between the electrode and the porous film can be enhanced. Furthermore, the ionic conductivity is enhanced due to the fine and even-sized pores. Consequently, the excited electrons from the porous film are easily collected at the first electrode, and hence, the photoelectric conversion efficiency is enhanced.

Furthermore, the additional porous film may be formed using a paste in which the metallic oxide particles are diffused so that it can have a sufficient thickness without increasing the number of processing steps. That is, a plurality of porous films with different characteristics can be formed to thereby enhance the characteristics of each film simultaneously.

## Claims

1. A solar cell comprising:
an electrode (11); and
a first porous film (13) formed on the electrode (11) with pores and containing metallic oxide particles (131),
wherein the metallic oxide particles (131) have a mean particle diameter of 5nm to 14nm.

2. The solar cell of claim 1, wherein the pores of the first porous film (13) have a mean pore size of 7.5nm to 15nm.

3. The solar cell of claims 1 or 2, wherein the first porous film (13) has a thickness of 10nm to 3000nm.

4. The solar cell of claim 3, wherein the thickness of the first porous film (13) is in the range of 10nm to 1000nm.

5. The solar cell of claim 1, wherein the metallic oxide particles (131) of the first porous film (13) comprise at least one oxide selected from the group consisting of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide and strontium titanium oxide.

6. The solar cell of claim 5, wherein the metallic oxide particles (131) comprise at least one oxide selected from the group consisting of titanium oxide, tin oxide, tungsten oxide, and zinc oxide.

7. The solar cell of claim 1, further comprising an additional porous film (53) formed on the first porous film (13) and containing metallic oxide particles (531), the metallic oxide particles (531) of the additional porous film (53) having a mean particle diameter greater than the mean particle diameter of the metallic oxide particles (131) of the first porous film (13).

8. The solar cell of claim 7, wherein the mean particle diameter of the metallic oxide particles (531) of the additional porous film (53) is in the range of 15nm to 50nm.

9. The solar cell of claim 7, wherein the additional porous film (53) is thicker than the first porous film (13).

10. The solar cell of claim 7, wherein the additional porous film (53) has a thickness of 5 µm to 40 µm.

11. The solar cell of claim 7, wherein metallic oxide particles of the additional porous film comprise at least one oxide selected from the group consisting of titanium oxide, zinc oxide, tin oxide, strontium oxide, indium oxide, iridium oxide, lanthanum oxide, vanadium oxide, molybdenum oxide, tungsten oxide, niobium oxide, magnesium oxide, aluminium oxide, yttrium oxide, scandium oxide, samarium oxide, gallium oxide and strontium titanium oxide.

12. The solar cell of claim 7, wherein the additional porous film (53) further comprises conductive micro particles and light scattering particles.

13. A method of manufacturing a solar cell, the method comprising the steps of:
providing a substrate (10) with an electrode (11) on its surface;
forming a first porous film (13) with pores and containing metallic oxide particles (131) through self-assembling process.

14. The method of claim 13, wherein the step of forming a first porous film (13) comprises preparing a self-assembling composition; coating the self-assembling composition onto an electrode; and heat-treating the coated composition.

15. The method of claim 14, wherein the self-assembling composition comprises a solvent, a block copolymer, and a metallic oxide precursor.

16. The method of claim 15, wherein the solvent is selected from the group consisting of acetyl acetone, alcohol, and a combination thereof.

17. The method of claim 15, wherein the block copolymer is a ethylene oxide / propylene oxide block copolymer.

18. The method of claim 15, wherein the metallic oxide precursor (131) is a metallic compound selected from the group consisting of alkoxides, chlorides, and combinations thereof.

19. The method of claim 14, wherein the self-assembling composition is coated onto the electrode (11) by any one coating method selected from the group consisting of dip coating, spin coating, and electrochemical coating.

20. The method of claim 14, further comprising forming an additional porous film (53) on the first porous film (13) by coating a paste in which metallic oxide particles (531) are diffused after heat-treating the coated composition to form the first porous film (13).

21. The method of claim 14, wherein the heat-treating is carried out at a temperature of between 350 °C and 500 °C.

22. The method of claim 15, wherein in the self-assembling composition, the solvent comprises from 60 to 90 wt.% of the self-assembling composition.
